# EUROPÄISCHE PATENTSCHRIFT

(11) **EP 3 790 196 B1**
(45) Veröffentlichungstag und Bekanntmachung des Hinweises auf die Patenterteilung: **15.07.2026**
(21) Anmeldenummer: 20000307.7
(22) Anmeldetag: 25.08.2020
(51) Int. Cl.: H03K 19/173, H03K 19/17736

(54) **SWITCHBOX**
SWITCH BOX
BOITIER DE COMMUTATION

(30) Priorität: 05.09.2019 DE 102019006293
(43) Veröffentlichungstag der Anmeldung: 10.03.2021
(73) Patentinhaber: Cologne Technology Holding GmbH, Köln 50668 (DE)
(72) Erfinder:

(56) Entgegenhaltungen:
- EP-A1- 3 783 649
- EP-A2- 0 746 106
- US-A1- 2001 022 519
- US-A1- 2019 379 380

## Beschreibung

Switchboxen werden insbesondere in integrierten Schaltungen mit programmierbarer Logik (z.B FPGAs) verwendet. Sie dienen dazu konfigurierbare Signalwege zwischen Logikblöcken herzustellen.

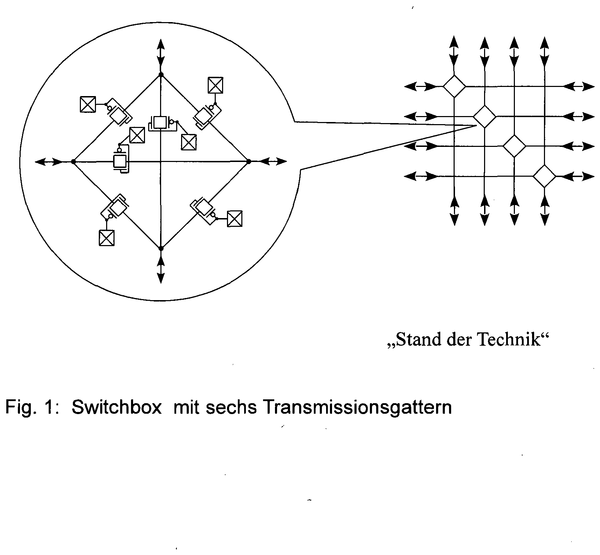

Nach dem Stand der Technik (Fig. 1) gibt es Switchboxen mit 6 Transmissionsgattern. Diese benötigen 6 Einstellbits. Diese Anordnung kann ein bis zwei Signale in jede Richtung routen. Nachteil hierbei ist, dass keinerlei Signalverstärkung eintritt und die Verbindung mehrerer Leitungssegmente schnell zu einer bedeutsamen Signalverzögerung und Degenerierung der Signalflanken führt.

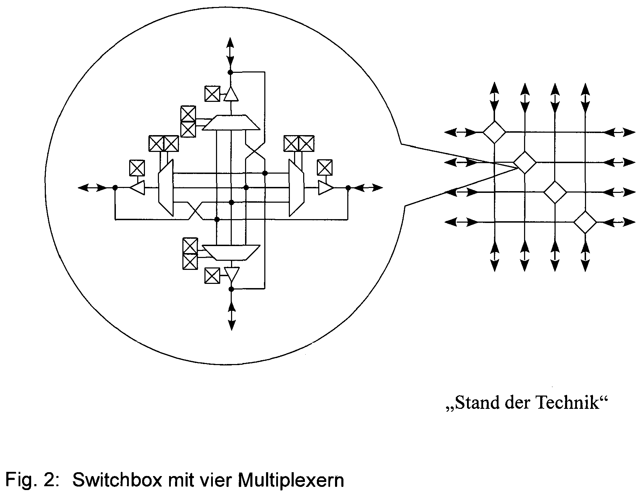

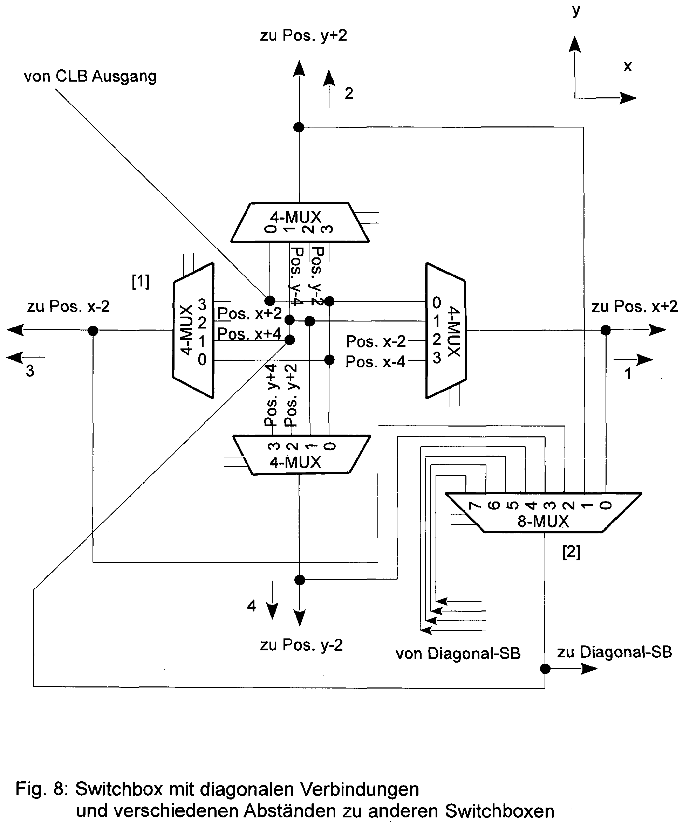

Dieses Problem kann durch die Verwendung von Multiplexern mit Signalverstärkung umgangen werden (Fig. 2). Diese Anordnung kann auch jedes Signal in jede Richtung weiterleiten. Hierbei können durch Tristatebuffer die Signalwege in verschiedenen Richtungen genutzt werden. Allerdings sind hierfür vier 4-zu-1 Multiplexer, 4 Tristatebuffer und 12 Einstellbits erforderlich, was den Flächenbedarf auf einem Chip erheblich vergrößert. Auch hier wird nach einer Folge von mehreren Verbindungen ein erhebliches Delay erzeugt, allerdings bleibt die Flankensteilheit der Signale durch die immer wieder vorgenommene Verstärkung am Ausgang der Multiplexer erhalten. Tristatemultiplexer zeigt auch die Patentschrift EP 0 746 106 A2 ins besondere in Fig. 8. Grundsätzlich mögliche Anordnungen zur Richtungsänderung bei Signalen sind auch in der US 2001/022519 A1 gezeigt.

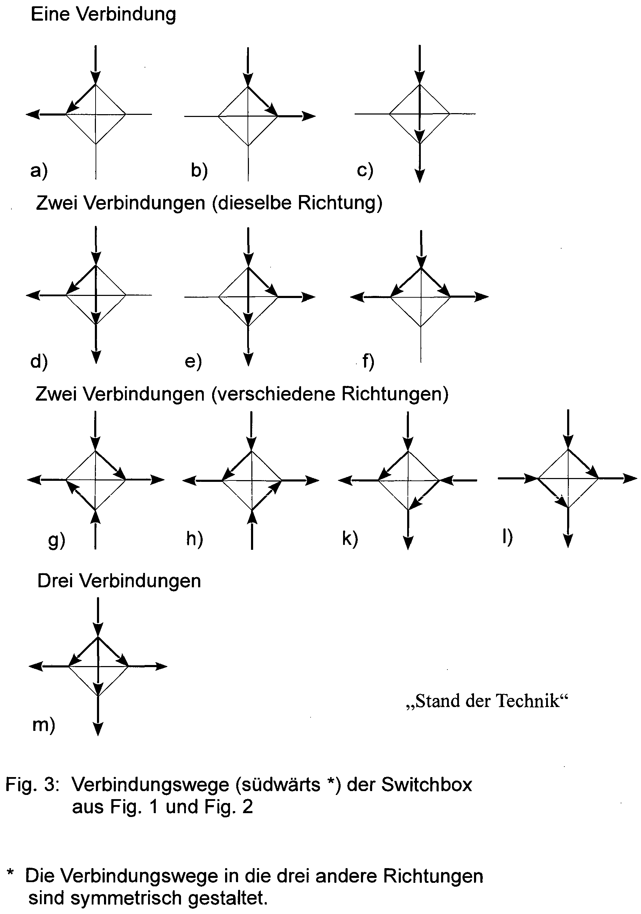

Die möglichen Signalwege sind in Fig. 3 (südwärts) gezeigt. Für alle Signalwege muss die Anordnung jeweils um 90 Grad gedreht werden.

Der vorliegenden Erfindung liegt die Aufgabe zu Grunde, eine Switchbox mit geringer Zahl von Multiplexern und Einstellbits vorzustellen, die ein Signal sowohl in Signalrichtung weiterleiten kann als auch einen Richtungswechsel herbeiführen kann.

Diese Aufgabe wird erfindungsgemäß durch die kennzeichnenden Merkmale der Patentansprüche gelöst.

Die Erfindung wird somit durch den unabhängigen Anspruch 1 definiert. Weitere Ausführungen werden in den Unteransprüchen beschrieben.

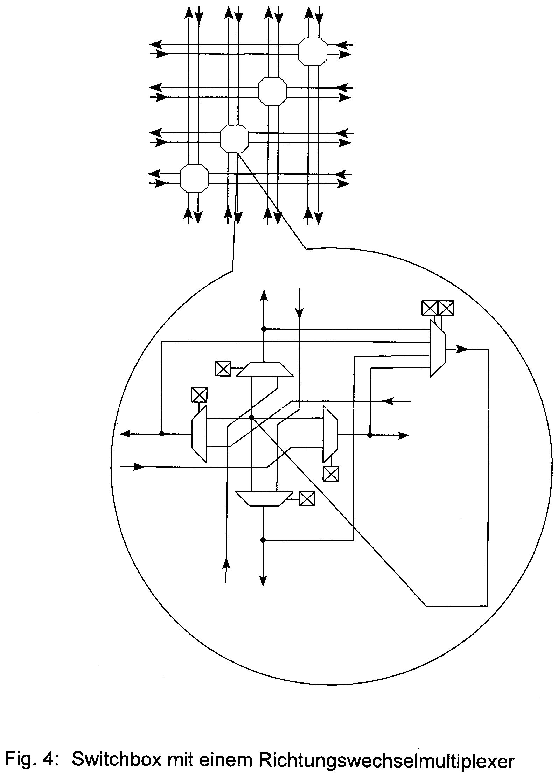

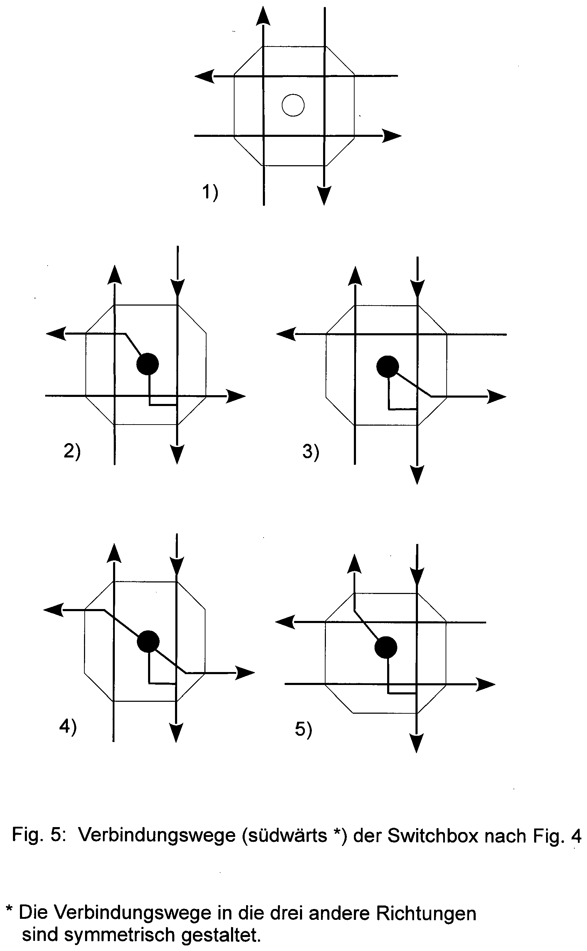

Gemäß der Figur 4 schalten die vier 1-zu-2 Richtungsmultiplexer dabei zwischen einer direkten Weiterleitung eines Signals in Signalrichtung und einem Richtungswechsel um. Mit welchem Signal dieser Richtungswechsel durchgeführt wird bestimmt sich dabei durch den 4-zu-1 Richtungswechselmultiplexer (Fig. 4). Es werden nur 6 Einstellbits benötigt. Ferner ist das Routing unidirektional, was Tristategatter und deren Delay überflüssig macht. Nicht benutzte Verbindungen können dadurch auch nicht floaten.

Die möglichen Signalwege sind in Fig. 5 (südwärts) gezeigt. Für alle Signalwege muss die Anordnung jeweils um 90 Grad gedreht werden.

Fig. 4 zeigt auch wie Richtungsmultiplexer und Richtungswechselmultiplexer verschaltet sind Der Richtungswechselmultiplexer treibt keine Signalleitungen zu anderen Switchboxen, sondern nur Signale zu den Richtungsmultiplexern, was durch die kurzen Leitungswege zu geringem Delay führt.

Fig. 6 zeigt eine Anordnung nach Anspruch 2 mit zwei Richtungswechselmultiplexern. Hierbei sind bestimmte Richtungswechsel von zwei Signalen gleichzeitig möglich. Die Anzahl der Einstellbits hat sich dabei gegenüber der Anordnung nach Fig. 4 nicht erhöht.

Die möglichen Signalwege sind in Fig. 7 (südwärts) gezeigt. Für alle Signalwege muss die Anordnung jeweils um 90 Grad gedreht werden.

Eine Anordnung nach Anspruch 3 ist in Fig. 8 gezeigt. Hier nimmt der Richtungswechselmultiplexer auch Signale von diagonal entfernten Switchboxen auf. Ferner wird der Ausgang vom Richtungswechselmultiplexern an diagonal gelegene Switchboxen weiter geleitet.

Das in Anspruch 4 benannte Merkmal ist ebenfalls in Fig. 8 gezeigt. Hier sind die Richtungsmultiplexer im x- und y-Abstand 2 und 4 mit anderen Switchboxen verbunden. Hierbei wird die jeweilige Signalrichtung in x- oder y-Richtung beibehalten.

Nach Anspruch 5 ist es auch sinnvoll, vorzugsweise in diagonaler Richtung, Verbindungen zu anderen Richtungswechselmultiplexern vorzusehen.

### Beschreibung der Zeichnungen:

Fig.1: Switchbox mit sechs Transmissionsgattern
   Übliche Anordnung nach dem Stand der Technik
Fig. 2: Switchbox mit vier Multiplexern
   Übliche Anordnung nach dem Stand der Technik
Fig. 3: Verbindungswege (südwärts *) der Switchbox
   aus Fig. 1 und Fig. 2.
   Die Verbindungswege in die drei andere Richtungen sind symmetrisch gestaltet.
Fig. 4: Switchbox mit einem Richtungswechselmultiplexer
   Erfindungsgemäße Anordnung mit einem Richtungswechselmultiplexer
Fig. 5: Verbindungswege (südwärts *) der Switchbox nach Fig. 4
   Die Verbindungswege in die drei andere Richtungen sind symmetrisch gestaltet.

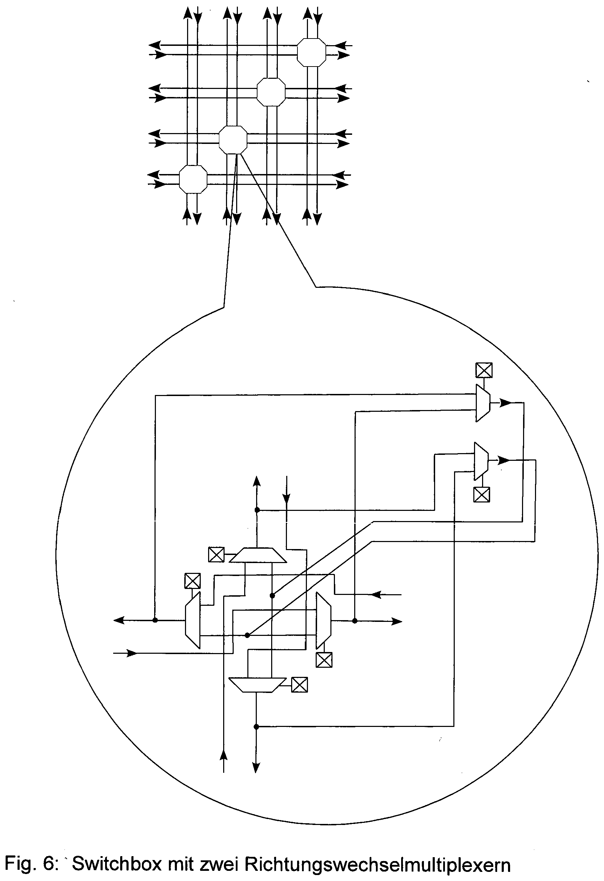

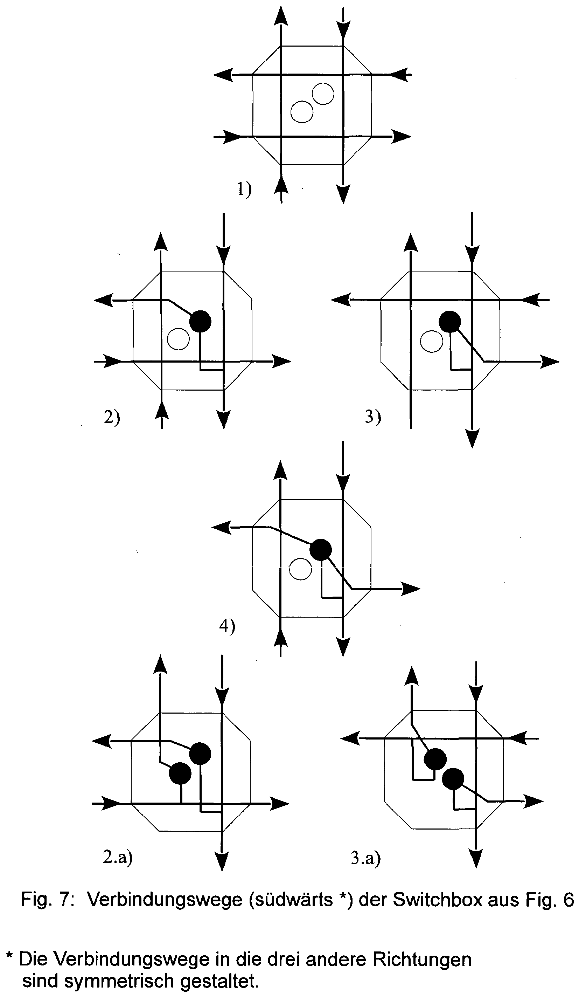

Fig. 6: Switchbox mit zwei Richtungswechselmultiplexern
   Erfindungsgemäße Anordnung mit zwei Richtungswechselmultiplexer
Fig. 7: Verbindungswege (südwärts *) der Switchbox aus Fig. 6
   Die Verbindungswege in die drei andere Richtungen sind symmetrisch gestaltet.
Fig. 8: Switchbox mit diagonalen Verbindungen
   und verschiedenen Abständen zu anderen Switchboxen

Es sind Verbindungen zu diagonalen Switchboxen über den Richtungswechselmultiplexer vorhanden.

Es ist darauf zu achten, dass die Zeichnungen die Erfindung nur beispielhaft offenbaren. Die Erfindung ist nicht auf diese Anwendungsbeispiele begrenzt.

## Patentansprüche

1. Switchbox bestehend aus Richtungsmultiplexern und mindestens einem Richtungswechselmultiplexer
wobei die Richtungsmultiplexer ein Signal nur in einer Richtung weiter leiten und der/die Richtungswechselmultiplexer dieses Signal in eine andere x/y-Richtung umleiten kann/können und
dass Signal-Eingänge der Richtungsmultiplexer vom/von Richtungswechselmultiplexer/n getrieben werden;
**dadurch gekennzeichnet, dass**:
die Richtungsmultiplexer vier Richtungsmultiplexer sind, wobei ein erstes Paar der Richtungsmultiplexer ein Signal nur in einer x/y Richtung weiter leiten kann und ein zweites Paar der Richtungsmultiplexer ein Signal nur in einer anderen x/y Richtung weiter leiten kann;
- wobei der mindestens eine Richtungswechselmultiplexer zwei Richtungswechselmultiplexer sind, deren Ausgänge jeweils mit einem Signal-Eingang der zwei Richtungsmultiplexer des ersten Paars von Richtungsmultiplexer und mit einem Signal-Eingang der zwei Richtungsmultiplexer des zweiten Paars von Richtungsmultiplexer verbunden sind, wobei die Signal-Eingänge eines der Richtungswechselmultiplexer mit jeweiligen Ausgängen des ersten Paars der Richtungsmultiplexer verbunden sind und die Signal-Eingänge eines anderen der Richtungswechselmultiplexer mit jeweiligen Ausgängen des zweiten Paars der Richtungsmultiplexer verbunden sind;
oder
- wobei der mindestens eine Richtungswechselmultiplexer ein Richtungswechselmultiplexer ist, dessen Ausgang mit einem Signal-Eingang aller Richtungsmultiplexer verbunden ist, wobei die Signal-Eingänge des Richtungswechselmultiplexer mit einem entsprechenden Ausgang der Richtungsmultiplexer verbunden sind.

2. Switchbox nach einem oder mehreren der vorausgehenden Ansprüche **dadurch gekennzeichnet,**
**dass** mindestens eine Verbindung zu einer diagonal verbindbaren anderen Switchbox besteht.

3. Switchbox nach einem oder mehreren der vorausgehenden Ansprüche **dadurch gekennzeichnet,**
**dass** die Richtungsmultiplexer mit Switchboxen in verschiedenen Abständen verbindbar sind.

4. Switchbox nach einem oder mehreren der vorausgehenden Ansprüche **dadurch gekennzeichnet,**
**dass** der/die Richtungswechselmultiplexer mit Switchboxen in verschiedenen Abständen verbindbar sind.

## Claims

1. Switchbox comprising directional multiplexers and at least one direction-changing multiplexer
whereby
the directional multiplexers forward a signal in only one direction and
the direction-changing multiplexer(s) can redirect this signal into a different x/y direction,
and
the signal inputs of the directional multiplexers are driven by the directional change multiplexer(s)
**characterised in that**:
the direction multiplexers are four direction multiplexers, wherein a first pair of the directional multiplexers can forward a signal only in one x/y direction and a second pair of the directional multiplexers can forward a signal only in a different x/y direction;
- wherein the at least one direction-switching multiplexer comprises two direction-switching multiplexers, the outputs of which are each connected to a signal input
of the two directional multiplexers of the first pair of directional multiplexers and with a signal input of the two directional multiplexers of the second pair of directional multiplexers
, wherein the signal inputs of one of the direction-changing multiplexers are connected to
respective outputs of the first pair of directional multiplexers and the signal inputs of another of the direction-switching multiplexers are connected to respective outputs of the second pair of direction multiplexers;
or
- wherein the at least one direction-switching multiplexer is a direction-switching multiplexer
whose output is connected to a signal input of all the direction multiplexers,
wherein the signal inputs of the direction-switching multiplexer are connected to a corresponding
output of the direction multiplexers.

2. A switchbox according to one or more of the preceding claims, characterised characterised
that at least one connection to another switchbox capable of being connected diagonally
switchbox.

3. Switchbox according to one or more of the preceding claims, characterised characterised
that the directional multiplexers can be connected to switchboxes at various distances.

4. A switchbox according to one or more of the preceding claims, characterised characterised
that the direction-changing multiplexer(s) can be connected to switch boxes at various distances.

## Revendications

1. Boîtier de commutation composé de multiplexeurs directionnels et d'au moins un multiplexeur de changement de direction
, dans lequel
les multiplexeurs directionnels ne transmettent un signal que dans une seule direction et
le ou les multiplexeurs de changement de direction peuvent rediriger ce signal dans une autre direction x/y
et
les entrées de signal des multiplexeurs directionnels sont pilotées par le ou les multiplexeurs de changement de direction
**caractérisé en ce que** :
les multiplexeurs de direction sont au nombre de quatre, une première paire de multiplexeurs directionnels ne peut acheminer un signal que dans une direction x/y et une deuxième
des multiplexeurs directionnels ne pouvant acheminer un signal que dans une autre direction x/y ;
- le ou les multiplexeurs de changement de direction comprenant deux multiplexeurs de changement de direction, dont les sorties sont respectivement reliées à une entrée de signal
des deux multiplexeurs directionnels de la première paire de multiplexeurs directionnels et à une
entrée de signal des deux multiplexeurs directionnels de la deuxième paire de multiplexeurs directionnels
, les entrées de signal de l'un des multiplexeurs de changement de direction étant sont reliées aux sorties respectives de la première paire de multiplexeurs de direction et les
entrées de signal d'un autre des multiplexeurs de changement de direction sont reliées aux sorties respectives de la deuxième paire de multiplexeurs de direction ;
ou
- le au moins un multiplexeur de changement de direction étant un multiplexeur de changement de direction
dont la sortie est connectée à une entrée de signal de tous les multiplexeurs de direction,
les entrées de signal du multiplexeur de changement de direction étant reliées à une sortie des multiplexeurs de direction.

2. Boîtier de commutation selon l'une ou plusieurs des revendications précédentes, **caractérisé en ce que**
caractérisée
qu'il existe au moins une connexion vers un autre
boîtier de commutation.

3. Boîtier de commutation selon une ou plusieurs des revendications précédentes, caractérisé
car
que les multiplexeurs directionnels peuvent être connectés à des boîtiers de commutation à différentes distances

4. Boîtier de commutation selon une ou plusieurs des revendications précédentes, caractérisé
car
que le ou les multiplexeurs de changement de direction peuvent être connectés à des boîtiers de commutation à différentes
distances.
